# FASCICULE DE BREVET EUROPEEN

(11) **EP 0 545 748 B1**
(45) Date de publication et mention de la délivrance du brevet: **29.01.1997**
(21) Numéro de dépôt: 92402982.0
(22) Date de dépôt: 04.11.1992
(51) Int. Cl.: H01R 13/24

(54) **Dispositif d'amenée de tension sur un porte-substrat**
Anordnung zur Zuführung einer Spannung auf einen Substrathalter
Device for supplying a voltage to a substrate holder

(30) Priorité: 06.11.1991 FR 9113686
(43) Date de publication de la demande: 09.06.1993
(73) Titulaire: COMMISSARIAT A L'ENERGIE ATOMIQUE, 75015 Paris (FR)
(72) Inventeur: Claude, Richard, F-38100 Grenoble (FR); Daviet, Jean-François, F-74960 Cran-Gevrier (FR); Montmayeul, Philippe, F-38190 Brignoud (FR); Peccoud, Louise, F-38640 Claix (FR)
(74) Mandataire: Dubois-Chabert, Guy

(56) Documents cités:
- EP-A- 0 121 936
- EP-A- 0 256 541
- EP-A- 0 269 446
- DE-A- 3 012 491

## Description

La présente invention concerne un dispositif d'amenée de tension sur une pièce conductrice constituant, par exemple, une électrode d'un porte-substrat. Ce dispositif, appelé aussi connecteur, trouve de nombreuses applications dans le domaine industriel de l'électronique notamment lors de la mise en oeuvre de procédés de traitement des substrats, par des réacteurs de dépôts ou de gravures, pour effectuer, par exemple, des dépôts ou des gravures ioniques réactives ou des dépôts de type CVD (en anglais : Chemical Vapour Deposition).

Lors de tels traitements, il est usuel d'effectuer des collages électrostatiques de substrats sur des porte-substrats. Ces collages électrostatiques nécessitent, cependant, d'amener de la tension généralement élevée (de l'ordre de 1 à 2 kV) sur les électrodes incluses dans le porte-substrat par l'intermédiaire de connecteurs. Dans le cas de traitements sous plasma, le porte-substrat étant généralement réalisé en un matériau isolant recouvert d'une couche de matériau conducteur de faible épaisseur, un courant radio-fréquence circule entre le connecteur et la couche conductrice et dégrade progressivement cette couche par claquage et par échauffement dû à un effet Joule. En effet, le connecteur d'amenée de tension traverse l'électrode radio-fréquence ; il se comporte de ce fait comme une antenne qui reçoit un courant électromagnétique, ce courant induisant des courants parasites dans le matériau conducteur du porte-substrat et vers le générateur de hautes tensions.

Afin de limiter les dégâts dus aux courants parasites, des dispositifs connus utilisent des valeurs de radiofréquence inférieures aux valeurs optimales généralement utilisées. Ces dispositifs ont alors des performances limitées.

Par ailleurs, dans certains dispositifs connus, les connecteurs sont fixes. Ils sont connectés au porte-substrat au moyen de tiges filetées par l'intermédiaire d'inserts métalliques. Cette technique a pour principal inconvénient d'être difficile à mettre en oeuvre dans une phase industrielle. De plus, sa maintenance est délicate car elle nécessite un vissage/dévissage du connecteur par rapport au porte-substrat.

Par ailleurs, le document DE-A-3 012 491 décrit un dispositif à contact permettant le contrôle de plaquettes de circuits imprimés électriques. Ce dispositif à contact comporte un piston de contact guidé longitudinalement dans une douille tubulaire et sur la face frontale duquel appuie un ressort hélicoïdal précontraint qui prend appui sur la douille.

La présente invention a justement pour but de proposer un connecteur permettant de remédier à ces inconvénients. Ce connecteur comporte un contact électrique en face arrière du porte-substrat ; ce contact est souple, ce qui permet au connecteur par l'intermédiaire d'un ressort, d'être en permanence en appui sur le porte-substrat. La fixation du connecteur avec le porte-substrat est donc réalisée indépendamment de la connexion électrique.

Le connecteur selon l'invention a, de plus, l'avantage d'être entièrement démontable, ce qui assure une simplicité de la maintenance.

En outre, le connecteur selon l'invention permet de protéger le porte-substrat et la source de tension contre les rayonnements électromagnétiques.

De façon plus précise, la présente invention concerne un connecteur de tension pour porte-substrat en milieu de rayonnement électromagnétique, caractérisé en ce qu'il comporte :
- une tige de connexion comportant des parois latérales et des surfaces de contact supérieure et inférieure, ladite tige de connexion étant apte à établir, par l'intermédiaire d'une surface de contact supérieure, un contact électrique avec une face inférieure du porte-substrat, et apte à assurer un isolement électromagnétique du porte-substrat ;
- des moyens élastiques électriquement conducteurs, disposés sous la tige de connexion et assurant un contact souple de la surface de contact supérieure de la tige de connexion sur la face inférieure du porte-substrat ;
- une embase, connectée à une source de tension, à l'intérieur de laquelle sont disposés les moyens élastiques ainsi qu'une partie au moins de la tige de connexion, ladite embase étant apte, d'une part, à établir une liaison électrique entre ladite source de tension et les moyens élastiques et, d'autre part, à assurer un isolement électromagnétique de la source de tension.

Selon un mode de réalisation, la tige de connexion est réalisée dans un matériau conducteur ayant une résistivité apte à assurer un isolement électromagnétique du porte-substrat.

Selon un autre mode de réalisation, la tige de connexion peut aussi être réalisée dans un matériau électriquement isolant recouvert d'une couche d'un matériau conducteur d'électricité ayant une résistivité apte à assurer un isolement électromagnétique du porte-substrat.

Avantageusement, les parois latérales de la tige de connexion sont recouvertes d'une couche de matériau isolant.

Les surfaces de contact inférieure et supérieure de la tige de connexion peuvent être métallisées.

Selon l'invention, le porte-substrat comporte un matériau électriquement isolant percé d'au moins une ouverture en regard de la surface de contact et recouvert d'une couche de matériau conducteur sur sa face supérieure, dans l'ouverture et au moins au voisinage de l'ouverture sur sa face inférieure. Le porte-substrat peut alors comporter, sur sa face inférieure, un épaulement réalisé dans le matériau isolant au voisinage de l'ouverture, cet épaulement étant au moins en partie recouvert de la couche de matériau conducteur.

Dans ce cas, la surface de contact supérieure de la tige de connexion est avantageusement chanfreinée de façon à s'emboîter dans l'épaulement du porte-substrat.

Selon un mode de réalisation de l'embase, celle-ci peut être réalisée dans un matériau électriquement conducteur. Le connecteur comporte alors une résistance électrique connectée entre la source de tension et l'embase pour protéger ladite source de tension d'effets résultant du rayonnement électromagnétique.

Selon un autre mode de réalisation de l'embase, ladite embase est réalisée dans un matériau électriquement isolant recouvert au moins partiellement d'une couche d'un matériau électriquement conducteur ayant une résistivité apte à protéger la source de tension d'effets parasites résultant du rayonnement électromagnétique et apte à assurer la continuité électrique entre la source et les moyens élastiques.

De façon avantageuse, le connecteur comprend une enceinte électriquement isolante, entourant en partie l'embase et la tige de connexion, de façon à les isoler de la source de rayonnement électromagnétique, à savoir de l'électrode 5.

Selon un mode de réalisation préféré, l'enceinte isolante et l'embase comportent des joints toriques assurant l'étanchéité du connecteur vis-à-vis du milieu extérieur.

D'autres avantages et caractéristiques de l'invention ressortiront de la description qui va suivre, donnée à titre illustratif, mais nullement limitatif, en référence aux dessins dans lesquels :
- la figure 1 représente une vue en coupe d'un connecteur selon l'invention ;
- la figure 2 représente une variante de la tige de connexion dans laquelle la surface de contact supérieure de ladite tige de connexion est chanfreinée ; et
- la figure 3 représente la tige de connexion appliquée sous le porte-substrat selon un mode de réalisation de l'invention différent de celui montré sur la figure 1.

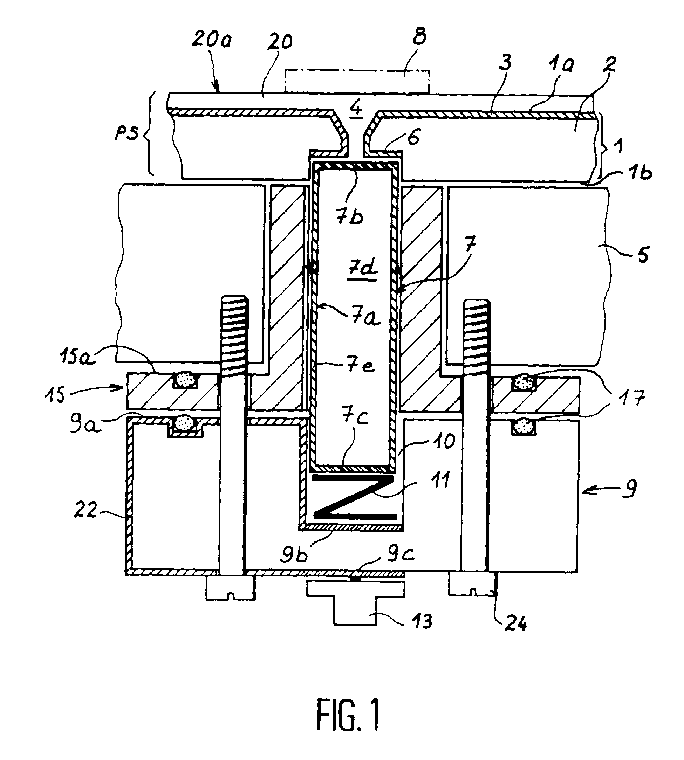

Sur la figure 1, on a représenté, en coupe, un exemple de connecteur de l'invention avec une partie du réacteur de traitement dans lequel ledit connecteur trouve une de ses applications. On voit donc sur cette figure, le porte-substrat PS, le connecteur, et une électrode 5 thermostatée qui est, lors d'un traitement sous plasma, portée à une tension de radiofréquence. L'ensemble du dispositif est généralement disposé (partiellement ou totalement) dans une chambre sous vide, cette chambre n'étant pas représentée sur la figure par mesure de simplification de ladite figure.

Le porte-substrat PS, appelé aussi porte-échantillon, comporte une pièce plane conductrice 1, réalisée à partir d'une semelle isolante épaisse 2 recouverte sur sa face supérieure d'une fine couche conductrice 3 agissant comme une électrode vis-à-vis du substrat 8 posé sur ledit porte-substrat. Ce substrat est isolé de la couche conductrice par une couche isolante 20 disposée sur la face supérieure 1a de la pièce 1. Dans la semelle 2, sont percés des ouvertures (appelés aussi trous) 4 dont la paroi interne est également recouverte d'une couche conductrice 3. De même, le voisinage desdits trous 4, sur la face inférieure 1b du porte-substrat PS, est recouvert d'une telle couche conductrice 3. L'ensemble semelle/couche conductrice constitue la pièce plane conductrice du porte-substrat.

Ces trous 4, disposés en regard des tiges de connexion 7, et d'une dimension sensiblement égale à 0,5 millimètre, par exemple, dans leur diamètre le plus petit, sont aussi nombreux que le nombre souhaité de connexions à la source de tension. En effet, chaque trou 4 permet la mise en place d'un connecteur. De façon avantageuse, la partie supérieure des trous 4 présente un diamètre supérieur à celui de sa partie inférieure pour permettre un meilleur dépôt du matériau conducteur 3 dans lesdits trous.

On comprendra, dans cette description, par matériaux conducteurs ou matériaux isolants les termes de matériaux électriquement conducteurs ou isolants électriques.

Le dépôt de la couche conductrice 3 sur la semelle isolante 2 et dans le trou 4 est réalisé, par exemple, par un procédé de CVD thermique (en anglais : Chemical Vapour Deposition). Sur la face inférieure 1b du porte-substrat PS, l'excès de matériau conducteur déposé est éliminé de façon à ne pas mettre en contact direct l'électrode 5 et ledit porte-substrat PS. Seul le matériau conducteur déposé au voisinage des trous 4 est conservé sur cette face inférieure 1b afin d'assurer les contacts électriques avec les tiges de connexion 7. Selon un mode de réalisation préféré de l'invention, le porte-substrat comporte sur sa face inférieure 1b, au voisinage des trous, un épaulement 6 augmentant le chemin électrique entre l'électrode 5 et la couche de matériau conducteur 6 qui recouvre alors partiellement le décrochement. Cet épaulement assure également un appui de la tige de connexion poussée par le ressort 11 sur le porte-substrat.

Il est alors possible d'alimenter en tension la face supérieure 1a de la pièce 1 grâce à la continuité électrique établie, par la couche conductrice 3, entre la face inférieure 1b, les trous 4 et la face supérieure 1a, le contact avec la source d'alimentation étant réalisé par la face arrière du porte-substrat, à savoir sa face inférieure 1b. Ainsi, entre la face supérieure 20a du porte-substrat sur laquelle est déposé le substrat 8 à traiter, et la couche 3, sont créées des forces électrostatiques via la couche isolante 20 permettant de maintenir le substrat sur le porte-substrat.

Pour amener la tension sur la pièce 1, on utilise un connecteur à contact souple. Ce connecteur comprend la tige de connexion 7, mobile dans le connecteur, l'embase 9 et les moyens élastiques 11 constitués, par exemple, d'un ressort conducteur.

La tige de connexion 7 est un cylindre dont le diamètre est supérieur au diamètre du trou 4.

Afin de protéger le porte-substrat des effets résultant du milieu de rayonnement électromagnétique dans lequel il est utilisé, la tige de connexion est électromagnétiquement blindée, c'est-à-dire qu'elle présente une impédance élevée.

Selon une première variante de la tige de connexion 7, celle-ci est réalisée dans un matériau isolant 7d (oxyde d'aluminium, quartz, etc.) recouvert sur ses parois latérales 7a et ses surfaces de contact 7b et 7c d'un film mince 7e de matériau faiblement conducteur (obtenu, par exemple, par dépôt de graphite ou de silicium faiblement dopé). Le film ainsi obtenu a, par exemple, une résistance de quelques 10⁶ Ohms. Cette variante est représentée sur la figure 1.

Selon une seconde variante de la tige de connexion 7, cette dernière est réalisée dans un matériau conducteur de forte résistivité (ayant, par exemple, une résistance de quelques 10⁶ Ohms), du type silicium intrinsèque ou carbone.

La tige 7 traverse l'électrode 5 pour relier la pièce 1 et l'embase 9. Elle entre en contact avec la pièce 1 simplement par application du connecteur sur la pièce 1.

Avantageusement, la tige de connexion 7 peut comporter, à ses extrémités 7c et 7b, une couche supplémentaire 26a et 26b de métal (obtenue, par exemple, à partir d'une laque d'argent, de peintures conductrices, etc.) assurant un meilleur contact avec la pièce 1 et les moyens élastiques 11.

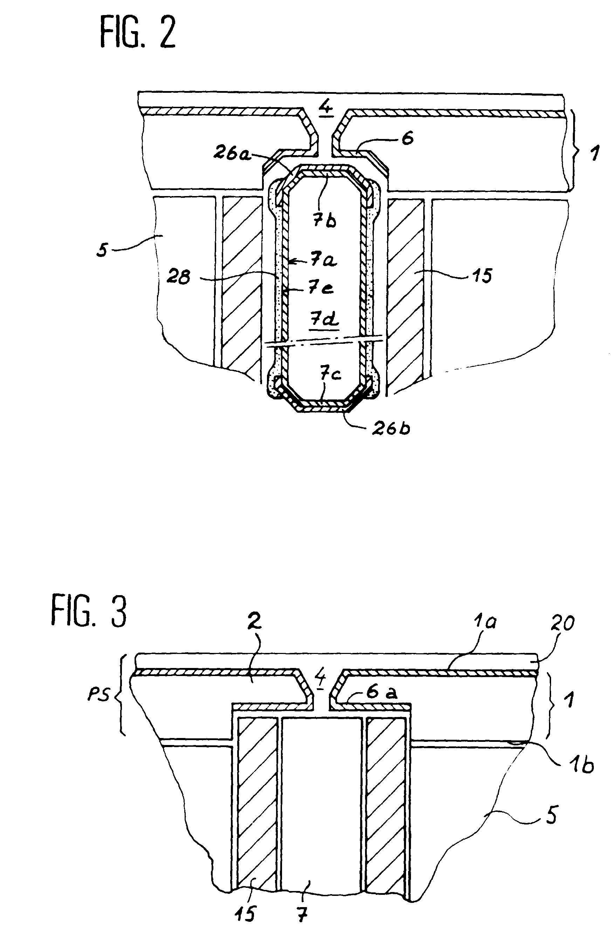

Sur la figure 2, on a représenté un mode de réalisation préféré de la tige de connexion 7. Selon ce mode de réalisation, la tige de connexion 7 est réalisée dans un matériau isolant 7d recouvert d'un film mince 7e de matériau conducteur sur ses parois 7a et ses surfaces de contact supérieure 7b et inférieure 7c. Chacune de ces surfaces de contact 7b et 7c est recouverte en plus d'une couche respective 26a et 26b de métal, de façon à augmenter encore la qualité du contact entre la tige de contact 7 et, respectivement, le porte-substrat 1 et le ressort 11.

Cette figure 2 représente, en outre, le mode de réalisation dans lequel la surface de contact supérieure 7b est chanfreinée, de façon à améliorer le contact avec la couche conductrice 6 recouvrant l'épaulement de l'ouverture 4.

Une réalisation plus particulière de cette tige de connexion consiste à chanfreiner également la surface de contact inférieure 7c de ladite tige de contact et à la recouvrir d'une couche 26b de métal pour améliorer son contact électrique avec le ressort 11. En effet, de tels chanfreins permettent, d'une part, un ajustement plus aisé entre la tige de contact et l'épaulement du porte-substrat et, d'autre part, une meilleure continuité électrique des couches conductrices du fait de la suppression des angles vifs.

D'après le mode de réalisation préféré, représenté sur cette figure 2, les parois 7a de la tige de connexion 7, déjà recouvertes du film mince 7e, sont, en outre, recouvertes d'une couche 28 de matériau isolant de passivation assurant la protection du film mince 7e. Cette couche 28 peut être réalisée par dépôt de silice, par peinture isolante, etc.

L'embase 9 peut également être réalisée selon plusieurs modes. Le premier mode de réalisation de cette embase 9 est représenté sur la figure 1. Selon ce mode, l'embase 9 est fabriquée dans un même matériau isolant que la tige de connexion 7 et recouverte au moins partiellement d'un même film mince conducteur 22, c'est-à-dire d'un film mince de mêmes caractéristiques physiques.

Selon un autre mode de réalisation de l'embase (non représenté sur les figures), cette dernière est réalisée dans un matériau conducteur, tel que du cuivre, de l'aluminium, etc. Pour assurer la protection de la source de tension à laquelle l'embase est connectée par la connexion 13 (qui sera décrite ultérieurement), vis-à-vis d'un courant parasite pouvant provenir de l'électrode 5, une résistance de valeur élevée (par exemple de quelques 10⁶ Ohms) est connectée entre cette source de tension et l'embase 9.

Cette embase 9 comporte un renfoncement 10 dans lequel la partie inférieure 7c de la tige de connexion 7 peut s'introduire. Au fond de ce renfoncement 10, est placé le ressort 11 conducteur, qui permet la continuité électrique entre l'embase 9 et la tige de connexion 7.

Ce ressort 11 assure de plus un contact souple entre le porte-substrat PS et le connecteur. En effet, le ressort 11 est positionné dans le renfoncement 10, et tend à pousser en permanence la tige de connexion 7 vers le haut de façon à toujours appliquer la surface supérieure 7b (ou surface de contact) de la tige de connexion 7 sur la partie conductrice de la face inférieure 1b du porte-substrat.

De plus, sur l'embase 9, une connexion 13 permet le branchement du connecteur vers la source d'alimentation, non représentée sur la figure. Cette connexion 13 peut être, par exemple, l'embase d'une prise électrique, par exemple du type BNC standard, fixée sur la surface de contact 9C de l'embase.

Selon un mode de réalisation de l'invention, l'embase 9 est entièrement recouverte du film mince conducteur 22.

Selon un autre mode de réalisation, seule(s) une ou plusieurs piste(s) conductrice(s), de résistivité suffisante pour assurer la protection électromagnétique de la source et de quelques millimètres de largeur, assurent la continuité électrique entre la connexion 13 et le ressort 11. Dans ce second cas, le fond du renfoncement 10 de l'embase est également recouvert par une couche mince conductrice de façon à permettre un bon contact avec le ressort 11.

De plus, le ressort étant simplement posé, il constitue une connexion douce. Pour améliorer les contacts électriques du ressort avec la tige de contact et l'embase, on effectue dans le cas de l'utilisation d'un matériau 7a et/ou 22 résistif un dépôt supplémentaire de matériau conducteur de faible résistance sur les surfaces de contact du matériau résistif.

Dans ce mode de réalisation de l'embase, les surfaces de contact 9b, 9c de ladite embase, avec, respectivement, le ressort 11 et la connexion 13, sont métallisées. Ces métallisations assurent un bon contact électrique, c'est-à-dire un contact électrique franc et reproductible. En effet, il est difficile d'obtenir un contact électrique franc avec un matériau très résistif comme celui utilisé dans l'invention, et plus particulièrement lorsqu'il existe une liaison douce entre les deux surfaces à mettre en contact. Cette métallisation des surfaces de contact peut être réalisée par exemple par le procédé de CVD thermique ou par un enduit durcissable, type résine époxy chargée à l'argent appliqué localement sur les surfaces à métalliser par-dessus le matériau résistif.

Selon l'invention, une enceinte 15, réalisée dans un matériau diélectrique, permet d'isoler le connecteur porté à haute-tension des autres éléments du réacteur et, notamment, ceux issus des électrodes radiofréquence 5.

Cette enceinte 15 entoure par ailleurs, dans sa partie longitudinale, la tige de connexion 7, c'est-à-dire qu'elle entoure les surfaces situées hors du renfoncement 10 et qui n'ont pas à établir de contact électrique avec le porte-substrat PS. Cette enceinte 15 recouvre également la partie supérieure 9a de l'embase 9 afin d'assurer son isolation électrique par rapport à l'électrode.

Dans le cas de l'utilisation du connecteur dans une enceinte de réacteur à pression différente de la pression atmosphérique et se refermant au niveau de l'électrode 5, l'enceinte 15 et l'embase 9 comportent chacune, sur leur surface supérieure respective 15a et 9a, un joint torique 17 permettant de rendre le connecteur étanche vis-à-vis de l'enceinte du réacteur.

Dans le cas où le connecteur est entièrement plongé dans une enceinte, ces joints sont inutiles.

Selon un mode de réalisation particulier de l'invention, le connecteur est par ailleurs fixé à l'électrode 5 par des moyens de maintien, tels que des vis 24 qui traversent de part en part l'embase 9 et l'enceinte 15.

Sur la figure 3, on a représenté un mode de réalisation de l'appui de la tige de connexion 7 sur le porte-substrat PS. En effet, afin de limiter encore les risques de formation de courants parasites, en particulier lorsque l'électrode 5 est polarisée en radiofréquence, on peut prévoir, dans le porte-substrat PS, un épaulement 6a de dimension supérieure à celle de l'épaulement 6 montré sur la figure 1. Ainsi, il est possible d'emboîter dans cet épaulement 6a à la fois la tige de connexion 7 et son enceinte 15. De cette façon, les arcs électriques aptes à amorcer des courants parasites sont interrompus car ils ne contournent que très difficilement un obstacle, à savoir l'enceinte 15. Cet emboîtage de l'enceinte 15 dans le porte-substrat s'effectue sur une distance typique de 2 à 3 millimètres.

D'après la description précédente, on comprend aisément que, non seulement la connexion peut être insensible au rayonnement électromagnétique, mais en plus, elle est entièrement démontable, ce qui permet une maintenance simple. Elle est de plus constituée de peu de pièces, ce qui permet un coût de fabrication intéressant.

Le dispositif décrit précédemment dans la description est appliqué à un porte-substrat électrostatique. Il est, bien sûr, entendu qu'il peut être appliqué à toutes sortes de portes-échantillons, voire à des pièces planes conductrices utilisées à des fins autres que le traitement d'échantillons.

## Revendications

1. Connecteur de tension pour porte-substrat en milieu de rayonnement électromagnétique, caractérisé en ce qu'il comporte :
- une tige de connexion (7) électromagnétiquement blindée comportant des parois latérales (7a) et des surfaces de contact supérieure (7b) et inférieure (7c), ces surfaces au moins étant conductrices de façon à assurer un contact électrique avec une face inférieure (1b) du porte-substrat (1) ;
- des moyens élastiques (11) électriquement conducteurs, disposés sous la tige de connexion et assurant un contact souple de la surface de contact supérieure de la tige de connexion sur la face inférieure du porte-substrat ;
- une embase (9), connectée à une source de tension et à l'intérieur de laquelle sont disposés les moyens élastiques ainsi qu'une partie au moins de la tige de connexion, ladite embase étant au moins en partie conductrice afin d'établir une liaison électrique entre ladite source de tension et les moyens élastiques et comportant des moyens résistifs assurant un isolement électromagnétique de la source de tension.

2. Connecteur selon la revendication 1, caractérisé en ce que la tige de connexion est réalisée dans un matériau conducteur ayant une résistivité apte à assurer un isolement électromagnétique du porte-substrat.

3. Connecteur selon la revendication 1, caractérisé en ce que la tige de connexion est réalisée dans un matériau électriquement isolant (7d) recouvert d'une couche (7e) d'un matériau conducteur d'électricité ayant une résistivité apte à assurer un isolement électromagnétique du porte-substrat.

4. Connecteur selon l'une quelconque des revendications 1 à 3, caractérisé en ce que les parois latérales (7a) de la tige de connexion sont recouvertes d'une couche de matériau isolant (28).

5. Connecteur selon l'une quelconque des revendications 1 à 4, caractérisé en ce que les surfaces de contact inférieure et supérieure de la tige de connexion sont métallisées.

6. Connecteur selon l'une quelconque des revendications 1 à 5, caractérisé en ce que le porte-substrat comporte un matériau électriquement isolant (2) percé d'au moins une ouverture (4) en regard de la surface de contact et recouvert d'une couche (3) de matériau conducteur sur sa face supérieure (la), dans l'ouverture et au moins au voisinage de l'ouverture sur sa face inférieure (1b).

7. Connecteur selon la revendication 6, caractérisé en ce que le porte-substrat comporte, sur sa face inférieure, un épaulement (6) réalisé dans le matériau isolant au voisinage de l'ouverture, cet épaulement étant au moins en partie recouvert de la couche de matériau conducteur.

8. Connecteur selon la revendication 7, caractérisé en ce que la surface de contact supérieure de la tige de connexion est chanfreinée de façon à s'emboîter dans l'épaulement du porte-substrat.

9. Connecteur selon l'une quelconque des revendications 1 à 8, caractérisé en ce que, l'embase étant réalisée dans un matériau électriquement conducteur, les moyens résistifs comportent une résistance électrique connectée entre la source de tension et l'embase pour protéger ladite source de tension d'effets parasites résultant du rayonnement électromagnétique.

10. Connecteur selon l'une quelconque des revendications 1 à 8, caractérisé en ce que l'embase est réalisée dans un matériau électriquement isolant recouvert, au moins partiellement, d'une couche d'un matériau électriquement conducteur ayant une résistivité apte à protéger la source de tension d'effets parasites résultant du rayonnement électromagnétique et apte à assurer la continuité électrique entre la source et les moyens élastiques, les moyens résistifs comprenant ledit matériau isolant et la couche de matériau conducteur.

11. Connecteur selon l'une quelconque des revendications 1 à 10, caractérisé en ce qu'il comprend une enceinte (15) électriquement isolante entourant, en partie, l'embase et la tige de connexion pour les isoler du milieu de rayonnement électromagnétique.

12. Connecteur selon la revendication 11, caractérisé en ce que l'enceinte isolante et l'embase comportent des joints toriques (17) assurant une étanchéité dudit connecteur vis-à-vis du milieu extérieur.

## Patentansprüche

1. Spannungsverbinder für einen Substrathalter in einem elektromagnetischen Strahlungsmilieu, **dadurch gekennzeichnet,** daß er umfaßt:
- einen elektromagnetisch abgeschirmten Verbindungsstift (7), Seitenwände (7a) und obere (7b) und untere (7c) Kontaktoberflächen umfassend, wobei wenigstens diese Flächen so leitfähig sind, daß sie einen elektrischen Kontakt mit einer Unterseite (1b) des Substrathalters (1) sicherstellen;
- elastische Mittel (11), elektrisch leitend, angeordnet unter dem Verbindungsstift, die einen nachgiebigen Kontakt zwischen der oberen Kontaktfläche des Verbindungsstifts und der Unterseite des Substrathalters sicherstellen;
- einen mit einer Spannungsquelle verbundenen Sockel (9), in dessen Innern sich die elastischen Mittel sowie wenigstens ein Teil des Verbindungsstifts befinden, wobei besagter Sockel wenigstens teilweise leitfähig ist, um eine elektrische Verbindung herzustellen zwischen der genannten Spannungsquelle und den elastischen Mitteln, und resistive Mittel umfaßt, die eine elektromagnetische Isolierung der Spannungsquelle sicherstellen.

2. Verbinder nach Anspruch 1, dadurch gekennzeichnet, daß der Verbindungsstift aus einem leitfähigen Material hergestellt ist, das eine Resistivität besitzt, die eine elektromagnetische Isolierung des Substrathalters sicherstellt.

3. Verbinder nach Anspruch 1, dadurch gekennzeichnet, daß der Verbindungsstift aus einem elektrisch isolierenden Material (7d) hergestellt ist, bedeckt von einer Schicht (7e) aus einem elektrisch leitenden Material mit einer Resistivität, die eine elektromagnetische Isolierung des Substrathalters sicherstellt.

4. Verbinder nach einem der Ansprüche 1 bis 3, dadurch gekennzeichnet, daß die Seitenwände (7a) des Verbindungsstifts überzogen sind mit einer Schicht aus isolierendem Material (28).

5. Verbinder nach einem der Ansprüche 1 bis 4, dadurch gekennzeichnet, daß die untere und die obere Kontaktfläche des Verbindungsstifts metallisiert sind.

6. Verbinder nach einem der Ansprüche 1 bis 5, dadurch gekennzeichnet, daß der Substrathalter ein elektrisch isolierendes Material (2) umfaßt, das gegenüber der Kontaktfläche von wenigstens einer öffnung (4) durchdrungen ist und auf seiner Oberseite (la), in der Öffnung und auf seiner Unterseite (1b) wenigstens in der Umgebung der Öffnung von einer leitfähigen Schicht (3) bedeckt ist.

7. Verbinder nach Anspruch 6, dadurch gekennzeichnet, daß der Substrathalter auf seiner Unterseite eine Schulter (6) umfaßt, hergestellt in dem isolierenden Material in der Umgebung der öffnung, wobei diese Schulter wenigstens teilweise bedeckt ist von der Schicht aus leitfähigem Material.

8. Verbinder nach Anspruch 7, dadurch gekennzeichnet, daß die obere Kontaktfläche des Verbindungsstifts so abgefast bzw. abgeschrägt ist, daß sie in die Schulter des Substrathalters hineinpaßt.

9. Verbinder nach einem der Ansprüche 1 bis 8, dadurch gekennzeichnet, daß der Sockel aus einem elektrisch leitenden Material hergestellt ist, wobei die resistiven Einrichtungen einen elektrischen Widerstand umfassen, angeschlossen zwischen der Spannungsquelle und dem Sockel, um die Spannungsquelle gegen Störeffekte zu schützen, die aus der elektromagnetischen Strahlung resultieren.

10. Verbinder nach einem der Ansprüche 1 bis 8, dadurch gekennzeichnet, daß der Sockel hergestellt ist aus einem elektrisch isolierenden Material, das wenigstens teilweise bedeckt ist von einer Schicht aus einem elektrisch leitenden Material mit einer Resistivität, die geeignet ist, die Spannungsquelle zu schützen vor Störeffekten, die aus der elektromagnetischen Strahlung resultieren, und geeignet ist, die elektrische Kontinuität zwischen der Quelle und den elastischen Mitteln sicherzustellen, wobei die resitiven Mittel besagtes isolierendes Material und die Schicht aus leitfähigem Material umfassen.

11. Verbinder nach einem der Ansprüche 1 bis 10, dadurch gekennzeichnet, daß er eine elektrisch isolierende Umfassung (15) enthält, die den Sockel und den Verbindungsstift teilweise umgibt, um sie vor dem elektromagnetischen Strahlungsmilieu zu schützen.

12. Verbinder nach Anspruch 11, dadurch gekennzeichnet, daß die isolierende Umfassung und der Sockel Ringdichtungen (17) umfassen, welche die Dichtheit des Steckers gegenüber der Außenatmosphäre sicherstellen.

## Claims

1. Voltage connector for a substrate holder in an electromagnetic radiation environment, characterized in that it includes:
- an electromagnetically screened connection rod (7) having side walls (7a) and upper (7b) and lower (7c) contact surfaces, at least these surfaces being conductive so as to make an electrical contact with a lower face (1b) of the substrate holder (1);
- electrically conductive elastic means (11), arranged under the connection rod and ensuring flexible contact of the upper contact surface of the connection rod on the lower face of the substrate holder;
- a base (9) which is connected to a voltage source and inside which the elastic means as well as at least a part of the connection rod are arranged, the said base being at least in part conductive in order to make an electrical connection between the said voltage source and the elastic means, and including resistive means which electromagnetically isolate the voltage source.

2. Connector according to Claim 1, characterized in that the connection rod is made of a conductive material having a resistivity capable of electromagnetically isolating the substrate holder.

3. Connector according to Claim 1, characterized in that the connection rod is made of an electrically insulating material (7d) covered with a layer (7e) of an electrically conductive material having a resistivity capable of electromagnetically isolating the substrate holder.

4. Connector according to any one of Claims 1 to 3, characterized in that the side walls (7a) of the connection rod are covered with a layer of insulating material (28).

5. Connector according to any one of Claims 1 to 4, characterized in that the lower and upper contact surfaces of the connection rod are metallized.

6. Connector according to any one of Claims 1 to 5, characterized in that the substrate holder includes an electrically insulating material (2) which is pierced with at least one opening (4) facing the contact surface and is covered with a layer (3) of conductive material on its upper face (la), in the opening and at least in the vicinity of the opening on its lower face (1b).

7. Connector according to Claim 6, characterized in that the substrate holder includes, on its lower face, a shoulder (6) formed in the insulating material in the vicinity of the opening, this shoulder being at least in part covered with the layer of conductive material.

8. Connector according to Claim 7, characterized in that the upper contact surface of the connection rod is chamfered so as to fit into the shoulder of the substrate holder.

9. Connector according to any one of Claims 1 to 8, characterized in that, the base being made of an electrically conductive material, the resistive means include an electrical resistor connected between the voltage source and the base, in order to protect the said voltage source from parasitic effects resulting from the electromagnetic radiation.

10. Connector according to any one of Claims 1 to 8, characterized in that the base is made of an electrically insulating material covered, at least partially, by a layer of electrically conductive material having a resistivity capable of protecting the voltage source from parasitic effects resulting from the electromagnetic radiation and capable of ensuring electrical continuity between the source and the elastic means, the resistive means comprising the said insulating material and the layer of conductive material.

11. Connector according to any one of Claims 1 to 10, characterized in that it comprises an electrically insulating enclosure (15), at least partly surrounding the base and the connection rod in order to isolate them from the electromagnetic radiation environment.

12. Connector according to Claim 11, characterized in that the insulating enclosure and the base have O-ring seals (17) which seal the connector from the external environment.
